## Europäisches Patentamt

## European Patent Office

## Office européen des brevets

(19)

(11) Veröffentlichungsnummer: **0 028 743**
**B1**

(12) **EUROPÄISCHE PATENTSCHRIFT**

(45) Veröffentlichungstag der Patentschrift:
08.06.83

(51) Int. Cl.³: **H 03 B 1/04**, H 03 K 6/00

(21) Anmeldenummer: 80106510.3

(22) Anmeldetag: 24.10.80

(54) Schaltung zur Erzeugung einer Sinusschwingung aus einer Dreiecksschwingung.

(30) Priorität: 08.11.79 DE 2945093

(43) Veröffentlichungstag der Anmeldung:
20.05.81 Patentblatt 81/20

(45) Bekanntmachung des Hinweises auf die Patenterteilung:
08.06.83 Patentblatt 83/23

(84) Benannte Vertragsstaaten:
DE FR GB

(73) Patentinhaber: Hewlett-Packard GmbH, Herrenberger Strasse 110, D-7030 Böblingen (DE)

(72) Erfinder: Traub, Stefan, Offenburger Strasse 16, D-7030 Böblingen (DE)

(74) Vertreter: Schulte, Knud, Dipl.-Ing., c/o Hewlett-Packard GmbH Europ. Patent- und Lizenzabteilung Postfach 1430 Herrenberger Strasse 130, D-7030 Böblingen (DE)

(56) Entgegenhaltungen:
DE-A-2 558 554
DE-A-2 613 338
DE-B-1 462 652

,,IEEE Journal of Solid-State Circuits'', Juni 1976, R. G. Meyer et al.: ,,The Differential Pair as a Triangle-Sine Wave Converter'', S. 418 bis 420.
,,Electronics Letters'', Bd. 13, Nr. 17, 18. August 1977, B. Gilbert: ,,Circuits for the Precise Synthesis of the Sine Function'', S. 506 bis 508.
,,Toute l'Electronique'', Nr. 441, März 1979, J.-P. Oehmichen: ,,La conversion triangle-sinus'', S. 75 bis 79.
,,Radio Fernsehen Elektronik'', Bd. 28, Nr. 7, 1979, H. Kühne: ,,Begrenzer für Sinussynthetisatoren'', S. 431 bis 433.
,,Der Elektroniker'', Nr. 1, 1977, S. EL 14.

## Schaltung zur Erzeugung einer Sinusschwingung aus einer Dreiecksschwingung

Die vorliegende Erfindung betrifft eine Schaltung zur Erzeugung eines Sinussignals aus einem linear ansteigenden bzw. abfallenden Signal unter Ausnutzung der nichtlinearen Kennlinie eines ersten Transistordifferenzverstärkers, zu welchem zwei zusätzliche Differenzverstärker ausgangsseitig parallelgeschaltet sind, deren Kennliniensteigungen der des ersten Differenzverstärkers entgegengesetzt sind.

Es ist bekannt, eine Sinusschwingung aus einer Dreiecksschwingung unter Verwendung eines Diodennetzwerks zu erzeugen. Ein solches Diodennetzwerk wandelt die ansteigende und die abfallende Rampe der Dreiecksschwingung derart in Geradenabschnitte um, dass eine Sinuskurve angenähert wird. Es ist offensichtlich, dass für eine möglichst genaue Annäherung der Sinuskurve sehr viele Geradenabschnitte benötigt werden, was wiederum zu einem erheblichen Schaltungsaufwand führt.

Es ist auch bekannt ("IEEE Journal of Solid-State Circuits", Juni 1976, S. 418 ff.), die nichtlineare Kennlinie eines Transistordifferenzverstärkers zur Umwandlung einer Dreieckskurve in eine Sinuskurve zu benutzen. Obwohl sich hierdurch eine Sinusschwingung mit relativ geringem Klirrfaktor erzeugen lässt, haftet ihr doch der Nachteil an, dass sie im Amplitudenmaximum bzw. -minimum einen Knick aufweist. Dies rührt daher, dass die nichtlineare Kennlinie des Differenzverstärkers selbst nicht in die Steigung Null ausläuft, sondern sich ihr nur asymptotisch nähert.

Bei einer anderen bekannten Schaltung (DE-OS Nr. 2613338) wird das Dreiecksignal parallel auf zwei Differenzverstärker gegeben, von denen einer eine nichtlineare und der andere eine lineare Kennlinie aufweist. Die Ausgangssignale dieser beiden Differenzverstärker werden voneinander subtrahiert. Die Gesamtschaltung hat dadurch eine Kennlinie, deren Steigung den Wert Null durchläuft und dann negativ wird. Wird sie genau bis zu den Punkten ausgesteuert, wo die Steigung Null ist, so entsteht eine Sinuskurve, deren Steigung keine Unstetigkeiten aufweist. Nachteilig bei dieser Schaltung ist jedoch die Differenzbildung, die nach den bekannten Regeln der Fehlerrechnung zu relativ grossen Fehlern im Ausgangssignal führen kann.

Aus "Electronics Letters", 18. August 1977, Bd. 13, Nr. 17, S. 506 bis 508, ist eine Schaltung zur Erzeugung einer Sinuskurve aus einem dem Phasenwinkel entsprechenden Eingangssignal bekannt. Dabei werden ebenfalls parallelgeschaltete Differenzverstärker benutzt. Die Kennlinien dieser Differenzverstärker sind abwechselnd positiv und negativ und durch entsprechende Vorspannungen an jeweils einer Transistorbasis jedes Differenzverstärkers so versetzt, dass die resultierende Kennlinie eine Sinuskurve mit mehreren Perioden approximiert. Je mehr Differenzverstärker dabei verwendet werden, desto schwächer werden auch die Knicke in den Amplitudenmaxima bzw. -minima. Eine hinreichende Abflachung dieser Knicke erfordert aber relativ viele Differenzverstärker.

Der Erfindung liegt die Aufgabe zugrunde, eine Schaltung der eingangs genannten Art zu schaffen, mit der bei Verwendung von lediglich drei Differenzverstärkern aus einer Dreiecksschwingung eine Sinusschwingung ohne Knicke, mit geringem Klirrfaktor und hoher Genauigkeit erzeugbar ist. Diese Aufgabe wird erfindungsgemäss unter der Voraussetzung, dass das linear ansteigende bzw. abfallende Signal ein Dreieckssignal ist, dadurch gelöst, dass die beiden Transistorbasen des ersten Differenzverstärkers mit je einer Transistorbasis jedes zusätzlichen Differenzverstärkers verbunden sind, dass die jeweils anderen Transistorbasen jedes zusätzlichen Differenzverstärkers miteinander verbunden und an eine gemeinsame Stromquelle angeschlossen sind und dass die Basen aller Transistoren der Differenzverstärker über Basiswiderstände mit Massepotential und die Emitter aller dieser Transistoren über Emitterwiderstände mit den den Differenzverstärkern zugeordneten Stromquellen verbunden sind, wobei die Werte der Basis- und Emitterwiderstände und der Stromquellen so gewählt sind, dass die resultierende Kennlinie der Schaltung beim Amplitudenmaximum des Dreieckssignals die Steigung Null hat.

Die erfindungsgemässe Schaltung liefert bei relativ geringem Schaltungsaufwand eine Sinusschwingung von sehr guter Qualität. Sie lässt sich auch mit sehr schnellen Schaltelementen, nach Bedarf auch als integrierte Schaltung ausführen und eignet sich daher auch zur Erzeugung von Sinusschwingungen sehr hoher Frequenzen.

Aus dem Unteranspruch 2 ergibt sich eine zweckmässige Temperaturkompensation.

Die Erfindung wird im folgenden anhand eines Ausführungsbeispiels in Verbindung mit der zugehörigen Zeichnung erläutert. In der Zeichnung zeigen:

Fig. 1 ein Schaltbild einer Schaltung zur Erzeugung einer Sinusschwingung aus einer Dreiecksschwingung;

Fig. 2 die Zusammensetzung der resultierenden Kennlinie der Schaltung gemäss Fig. 1; und

Fig. 3 eine von der Schaltung gemäss Fig. 1 erzeugte Sinusschwingung zusammen mit einer Fehlerkurve, die deren Abweichung von der idealen Sinusform angibt.

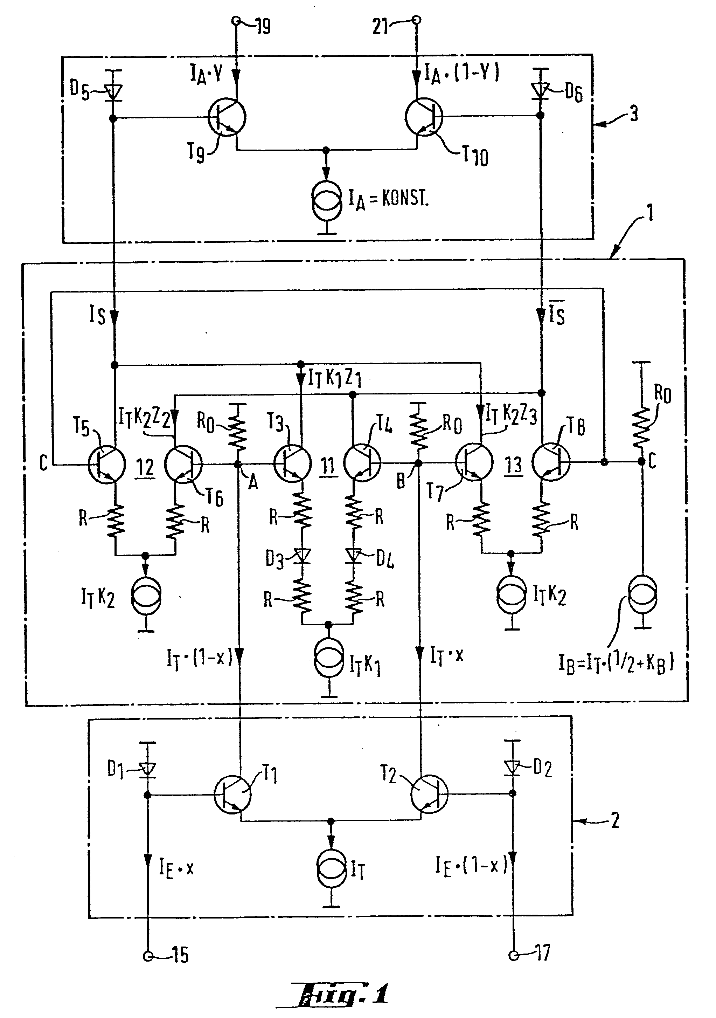

Die in Fig. 1 dargestellte Schaltung gliedert sich in drei Hauptteile, nämlich einen Sinusformer 1, einen Eingangsmultiplizierer 2 und einen Ausgangsmultiplizierer 3. Der Sinusformer 1 weist seinerseits drei Differenzverstärker 11, 12 und 13 auf, deren Arbeitsweise weiter unten erläutert wird.

Der Eingangsmultiplizierer 2 weist zwei npn-Transistoren $T_1$ und $T_2$ auf, deren Emitter mit einer gemeinsamen Stomquelle $I_T$ verbunden sind. Die Basen der Transistoren $T_1$ und $T_2$ sind einerseits über Dioden $D_1$ und $D_2$ mit Masse und andererseits mit Eingangsklemmen 15 bzw. 17 verbunden. Den Eingangsklemmen 15 und 17 werden Eingangsströme $I_E \cdot X$ und $I_E \cdot (1-X)$ zugeführt. Nimmt man $I_E$ als konstant an, so ist X die Variation des Eingangsstroms, hat also im vorliegenden Fall einen dreiecksförmigen Verlauf.

Der Eingangsmultiplizierer 2 dient dazu, den temperaturunabhängigen Eingangsstrom in einen temperaturabhängigen zu verwandeln. Die Stromquelle $I_T$ ist daher so aufgebaut, dass sie einen Strom abgibt, der proportional zur absoluten Temperatur ist. Die Ausgangsströme des Eingangsmultiplizierers 2 betragen nun $I_T \cdot (1-X)$ und $I_T \cdot X$ und sind somit ebenfalls der absoluten Temperatur proportional. Die diese Ströme führenden Kollektoren der Transistoren $T_1$ und $T_2$ sind mit Schaltungspunkten A und B verbunden, welche über Widerstände $R_0$ mit Masse verbunden sind und zwischen denen ein der absoluten Temperatur proportionaler Spannungsabfall entsteht.

Der Schaltungspunkt A ist ausserdem mit der Basis des einen npn-Transistors $T_3$ des Differenzverstärkers 11 sowie mit der Basis eines npn-Transistors $T_6$ verbunden, der zum Differenzverstärker 12 gehört. Der Schaltungspunkt B ist mit der Basis des anderen npn-Transistors $T_4$ des Differenzverstärkers 11 sowie mit der Basis eines npn-Transistors $T_7$ verbunden, der zum Differenzverstärker 13 gehört. Die jeweils anderen npn-Transistoren $T_5$ bzw. $T_8$ der Differenzverstärker 12 bzw. 13 liegen mit ihren Basen an einem Schaltungspunkt C, der einerseits über einen Widerstand $R_0$ mit Masse und andererseits mit einer Stromquelle $I_B = I_T$ ($\frac{1}{2} + K_B$) verbunden ist. $K_B$ ist eine empirisch zu ermittelnde Konstante (s.u.).

Der Differenzverstärker 11 ist der Hauptformer, während die Differenzverstärker 12 und 13 der Korrektur seiner Kennlinie dienen, derart, dass die erhaltene Schwingung keine Unstetigkeiten in ihrer Steigung aufweist. Der Differenzverstärker 11 weist ausser den Transistoren $T_3$ und $T_4$ noch zwei Dioden $D_3$ und $D_4$ auf, über die die Emitter der beiden Transistoren $T_3$ und $T_4$ an eine gemeinsame Stromquelle $I_T K_1$ angeschlossen sind. Bahn-, Leitungs- und diskrete Emitterwiderstände der einzelnen Differenzverstärker 11, 12 und 13 sind schematisch durch Widerstände R dargestellt. Die Emitter der Transistoren $T_5$ und $T_6$ sowie $T_7$ und $T_8$ sind jeweils mit einer Stromquelle $I_T K_2$ verbunden. $K_1$ und $K_2$ sind empirisch zu ermittelnde Konstanten (s.u.).

Zwischen den Spannungen zwischen den Punkten A und B, A und C und B und C einerseits und den Ausgangsströmen der Differenzverstärker 11, 12 und 13 andererseits besteht folgender Zusammenhang:

$$U_{AB} = 2\,U_T \ln\frac{Z_1}{1-Z_1} + 2\,I_T R K_1\,(2Z_1 - 1) \quad (1)$$

$$U_{AC} = U_T \ln\frac{Z_2}{1-Z_2} + I_T R K_2\,(2Z_2 - 1) \quad (2)$$

$$U_{BC} = U_T \ln\frac{Z_3}{1-Z_3} + I_T R K_2\,(2Z_3 - 1) \quad (3)$$

Dabei ist $U_T$ die sogenannte Temperaturspannung, die proportional zur absoluten Temperatur ist (im vorliegenden Beispiel sind alle Transistoren typengleich. $Z_1$, $Z_2$ und $Z_3$ sind veränderliche Koeffizienten ähnlich wie X am Eingang des Sinusformers 1.

Die Kollektoren der Transistoren $T_3$, $T_5$ und $T_7$ einerseits und der Transistoren $T_4$, $T_6$ und $T_8$ andererseits sind miteinander verbunden und geben die Gesamtströme $I_S$ bzw. $\overline{I}_S$ ab. Die Ströme $I_S$ und $\overline{I}_S$ haben bereits sinusförmigen Verlauf, sind aber noch temperaturabhängig. Mittels des Ausgangsmultiplizierers 3 wird diese Temperaturabhängigkeit beseitigt. Der Ausgangsmultiplizierer 3 besteht aus zwei npn-Transistoren $T_9$ und $T_{10}$, deren Emitter an eine gemeinsame Stromquelle $I_A$ = KONST. angeschlossen sind. Die Basen der Transistoren $T_9$ und $T_{10}$ sind einerseits über Dioden $D_5$ und $D_6$ mit Masse und andererseits mit den die Ströme $I_S$ und $\overline{I}_S$ führenden Ausgängen des Sinusformers 1 verbunden. Die Ausgangsströme des Ausgangsmultiplizierers 3 an Klemmen 19 und 21 betragen $I_A \cdot Y$ bzw. $I_A \cdot (1-Y)$. Dabei ist Y der sinusförmig veränderliche Koeffizient.

Im vorbeschriebenen Ausführungsbeispiel liegt X zwischen 0,25 und 0,75 und $I_T$ beträgt 10 mA bei 25° C. Folgende zweckmässige Werte wurden empirisch ermittelt:

$$R_1 = 4{,}4\ \Omega$$
$$R_0 = 40\ \Omega$$
$$K_1 = 0{,}64$$
$$K_2 = 0{,}179$$
$$K_B = 0{,}35$$

Die Ausgangssignale an den Klemmen 19 und 21 der Schaltung gemäss Fig. 1 sind temperaturunabhängig. In den Gleichungen 1 bis 3 sind die linken Seiten und auf den rechten Seiten sowohl der logarithmische Term als auch der lineare Term proportional zur absoluten Temperatur. Dies gilt auch für die Ströme $I_S$ und $\overline{I}_S$, wie oben bereits erwähnt wurde. Im Ausgangsmultiplizierer 3 wird dann die Temperaturunabhängigkeit kompensiert.

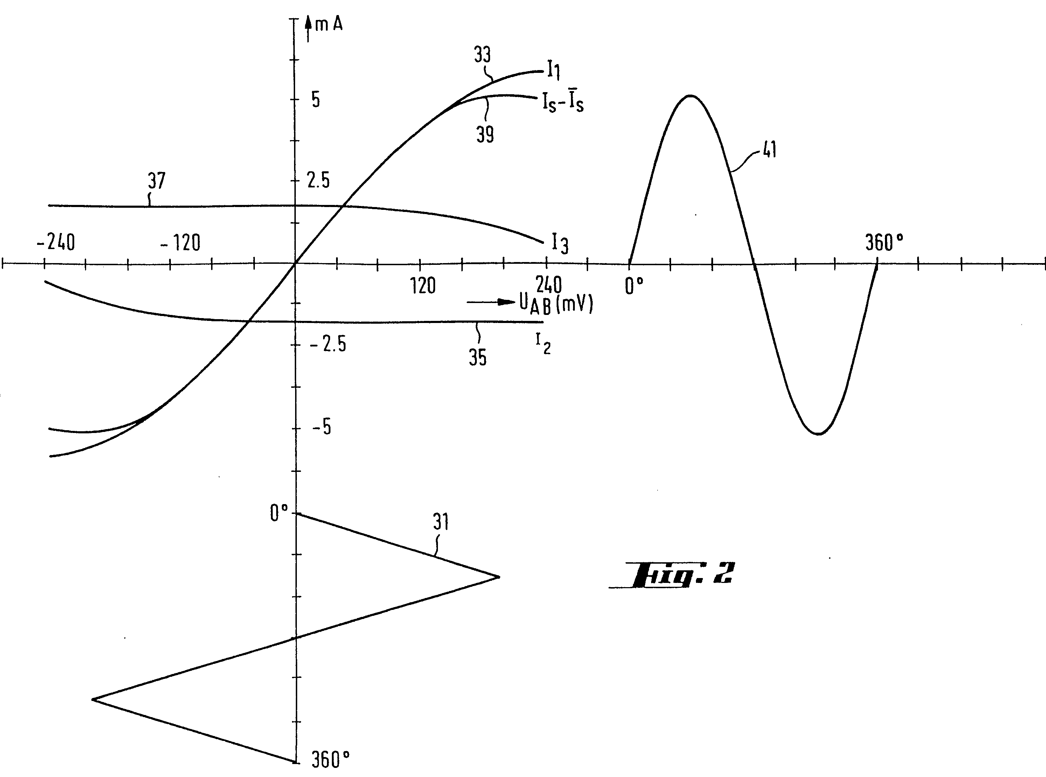

In Fig. 2 ist dargestellt, wie sich die resultierende Kennlinie des Sinusformers 1 gemäss Fig. 1 zusammensetzt. Mit 31 ist die Dreiecksschwingung bezeichnet, die das Eingangssignal $U_{AB}$ des Sinusformers 1 bildet. Mit 33 ist die Kennlinie des Differenzverstärkers 11 bezeichnet. Es ist ersichtlich, dass die Kennlinie 33 sich für grosse positive und negative Spannungen $U_{AB}$ jeweils einer waagerechten Asymptote nähert, dass ihre Steigung jedoch nicht Null wird. Letzteres lässt sich jedoch durch lineare Überlagerung der Kennlinien 35 und 37 der Differenzverstärker 12 und 13 (Fig. 1) erreichen, wie aus dem Diagramm gemäss Fig. 2 hervorgeht. Die daraus resultierende Kennlinie ist mit 39 bezeichnet. Die Kurve 41 ist die Ausgangssinusschwingung des Differenzstroms $I_S - \overline{I}_S$ in Abhängigkeit von Phasenwinkel.

In Fig. 2 bedeuten $I_1$, $I_2$ und $I_3$ die Differenzströme der einzelnen Differenzverstärker 11, 12 bzw. 13. Dabei gilt

$$I_1 = I_Z K_1\,(2Z_1 - 1)$$
$$I_2 = I_T K_2\,(2Z_2 - 1)$$
$$I_3 = I_T K_2\,(2Z_3 - 1)$$
$$I_S - \overline{I}_S = I_1 + I_2 + I_3$$

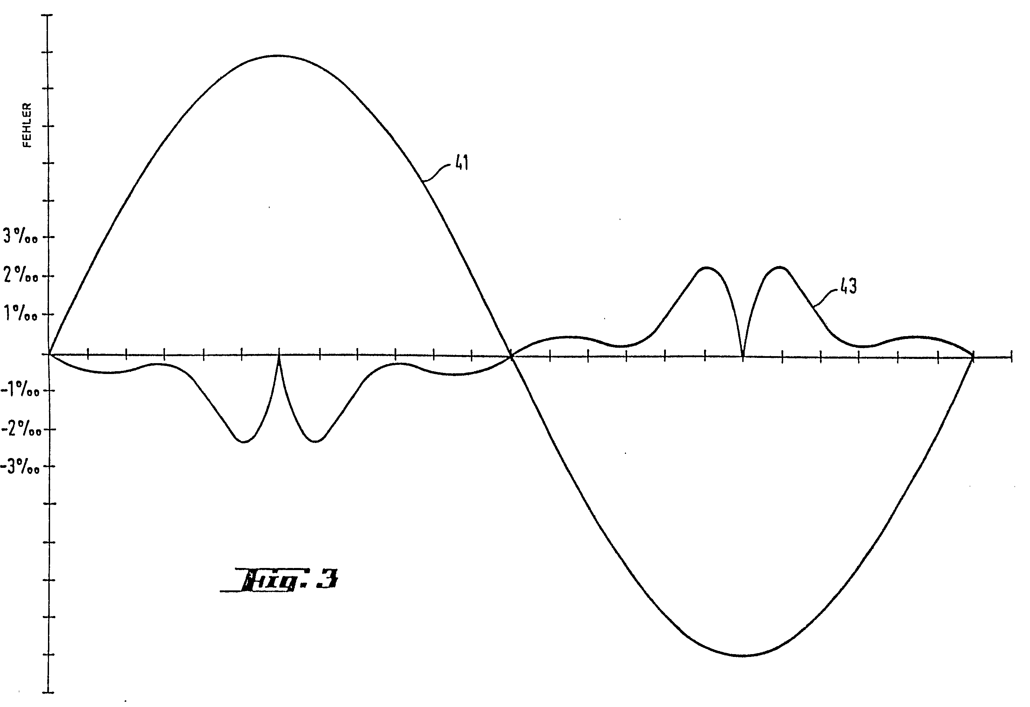

Fig. 3 zeigt die Abweichung der Sinuskurve 41 (Fig. 2) von der idealen Sinusform beim vorliegenden Ausführungsbeispiel. Mit 43 ist dabei die Fehlerkurve bezeichnet. Es ist ersichtlich, dass der Fehler maximal ±2,2‰ beträgt. Der Klirrgrad liegt bei 60 dB.

Die vorbeschriebene Schaltung eignet sich für Frequenzen bis 100 MHz (Transitfrequenz 1 GHz).

## Patentansprüche

1. Schaltung zur Erzeugung eines Sinussignals aus einem linear ansteigenden bzw. abfallenden Signal unter Ausnutzung der nichtlinearen Kennlinie eines ersten Transistordifferenzverstärkers (11), zu welchem zwei zusätzliche Differenzverstärker (12, 13) ausgangsseitig parallelgeschaltet sind, deren Kennliniensteigungen der des ersten Differenzverstärkers entgegensetzt sind, dadurch gekennzeichnet, dass das linear ansteigende bzw. abfallende Signal ein Dreieckssignal ist, dass die beiden Transistorbasen des ersten Differenzverstärkers (11) mit je einer Transistorbasis jedes zusätzlichen Differenzverstärkers (12, 13) verbunden sind, dass die jeweils anderen Transistorbasen jedes zusätzlichen Differenzverstärkers miteinander verbunden und an eine gemeinsame Stromquelle ($I_B$) angeschlossen sind, und dass die Basen aller Transistoren ($T_3$-$T_8$) der Differenzverstärker (11, 12, 13) über Basiswiderstände ($R_o$) mit Massepotential und die Emitter aller dieser Transistoren über Emitterwiderstände (R), mit den den Differenzverstärkern zugeordneten Stromquellen ($I_TK_2$, $I_TK_1$, $I_TK_2$) verbunden sind, wobei die Werte der Basis- und der Emitterwiderstände und der Stromquellen so gewählt sind, dass die resultierende Kennlinie der Schaltung beim Amplitudenmaximum des Dreieckssignals die Steigerung Null hat.

2. Schaltung nach Anspruch 1, dadurch gekennzeichnet, dass den Differenzverstärkern (11, 12, 13) ein Eingangsmultiplizierer (2) vor- und ein Ausgangsmultiplizierer (3) nachgeschaltet sind, und dass der Eingangsmultiplizierer (2) und alle Differenzverstärker (11, 12, 13) mit einem zur absoluten Temperatur proportionalen Strom ($I_T$) gespeist werden, während der Ausgangsmultiplizierer (3) mit einem konstanten Strom ($I_A$) gespeist wird.

## Claims

1. Circuitry for producing a sine signal from a linearly increasing, respectively decreasing, signal by utilizing the non-linear characteristic of a first transistor differential amplifier (11) to which the outputs of two additional differential amplifiers (12, 13) are switched in parallel, the characteristic slopes of these additional differential amplifiers being opposite to that of the first differential amplifier, characterized in that the linearly increasing, respectively decreasing, signal is a triangular signal, in that both transistor bases of the first differential amplifier (11) are coupled to one of the transistor bases of every additional differential amplifier (12, 13), in that the other transistor bases of each additional differential amplifier are coupled to each other and are connected to a common current source ($I_B$), and in that the bases of all transistors ($T_3$-$T_8$) of the differential amplifiers (11, 12, 13) are coupled via base resistors ($R_o$) to ground potential and the emitters of all these transistors are coupled via emitter resistors (R) to the current sources ($I_TK_2$, $I_TK_1$, $I_TK_2$) assigned to the differential amplifiers, whereby the values of the base and emitter resistors and of the current sources are chosen so that the resulting characteristic of the circuitry at the amplitude maximum of the triangular signal has a zero slope.

2. Circuit according to claim 1, characterized in that an input multiplier (2) precedes the differential amplifiers (11, 12, 13) and an output multiplier (3) succeeds them, and in that the input multiplier (2) and all differential amplifiers (11, 12, 13) are fed with a current ($I_T$) being proportional to the absolute temperature, whereas the output multiplier (3) is fed with a constant current ($I_A$).

## Revendications

1. Circuit délivrant un signal sinusoïdal à partir d'un signal croissant et décroissant linéairement, avec utilisation de la caractéristique non linéaire d'un premier amplificateur différentiel à transistors (11), dont la sortie est couplée en parallèle avec deux amplificateurs différentiels (12, 13) supplémentaires, dont la caractéristique présente une pente opposée à celle du premier amplificateur différentiel, ledit circuit étant caractérisé en ce que le signal croissant et décroissant linéairement est un signal triangulaire; les deux bases de transistor du premier amplificateur différentiel (11) sont reliées chacune à une base de transistor de chaque amplificateur différentiel (12, 13); les autres bases de transistor de chaque amplificateur différentiel sont reliées entre elles et à une source de courant commune ($I_B$); et les bases de tous les transistors ($T_3$-$T_8$) des amplificateurs différentiels (11, 12, 13) sont reliées par des résistances de base ($R_o$) au potentiel de masse, et les émetteurs de tous ces transistors sont reliés par des résistances d'émetteur (R) aux sources de courant ($I_TK_2$, $I_TK_1$, $I_TK_2$) affectées aux amplificateurs différentiels, les valeurs des résistances de base, des résistances d'émetteur et des sources de courant étant choisies de façon que la caractéristique résultante du circuit présente une pente nulle au maximum d'amplitude du signal triangulaire.

2. Circuit selon la revendication 1, caractérisé en ce qu'un multiplicateur d'entrée (2) et un multiplicateur de sortie (3) sont branchés respectivement en amont et en aval des amplificateurs différentiels (11, 12, 13); et le multiplicateur d'entrée (2) et tous les amplificateurs différentiels (11, 12, 13) sont alimentés par un courant ($I_T$) proportionnel à la température absolue, tandis que le multiplicateur de sortie (3) est alimenté par un courant constant ($I_A$).

*Fig. 1*

Fig. 2

0 028 743

_Fig. 3_